# EUROPEAN PATENT SPECIFICATION

(11) **EP 0 664 491 B1**
(45) Date of publication and mention of the grant of the patent: **28.01.1998**
(21) Application number: 94307902.0
(22) Date of filing: 27.10.1994
(51) Int. Cl.: G03F 7/075, G03F 7/033

(54) **Waterborne photoresists having polysiloxanes**
Wässrige Emulsionsphotoresiste mit Polysiloxanen
Photoréserves en émulsion aqueuse contenant des polysiloxanes

(30) Priority: 25.01.1994 US 186875; 18.02.1994 US 199037; 30.03.1994 US 221313
(43) Date of publication of application: 26.07.1995
(73) Proprietor: Morton International, Inc., Chicago, Illinois 60606-1596 (US)
(72) Inventor: Barr, Robert K., Laguna Niguel, California 92677 (US); Derrico, Gene R., Mission Viejo, California 91692 (US)
(74) Representative: Bankes, Stephen Charles Digby

(56) References cited:
- WO-A-93/14443
- US-A- 5 045 435

## Description

The present invention is directed to photoresists, such as those used for forming printed circuit boards and more particularly to waterborne, liquid applied photoresists.

Photoimageable compositions useful as resists for forming printed circuits, printing plate, solder masks or the like have been used for some time now. The earliest photoresists were solvent-borne and solvent-developable. The development of aqueous-developable resists represented an advance in reducing solvent emissions in the immediate workplace and in the general environment. The continued emphasis in reducing organic solvent both from the workplace and from the general environment has spurred the search for waterborne photoresists which are formulated and applied as aqueous liquids.

U.S. patent No. 5,045,435, describes a waterborne photoresist composition which is developable in alkaline aqueous solution. The composition comprises a multifunctional monomer, a photoinitiator and a latex of water-insoluble carboxylated acrylic copolymer. To stabilize the composition and to adjust the viscosity, this patent teaches neutralizing the latex polymer to at least 25% with a base, such as ammonia, another amine, or sodium hydroxide.

To most faithfully reproduce the pattern of artwork with high resolution, contact printing with the artwork (or phototool) laid in direct contact with the photoimageable composition layer is usually required. Contact printing is required to achieve resolution of small (less than 76.2 µm 3 mil) circuit geometries. If contact printing is to be used, however, the surface of the photoimageable composition layer must be sufficiently non-tacky so as not to adhere to the artwork. Transfer of even some photoimageable composition may either permanently damage the artwork or require extensive cleaning of the artwork.

WO-A-93/14443 discloses a photoresist composition for producing non-tacky films, comprising an aqueous dispersion of a water-dispersible photosensitive ionic polymeric material and a polyalkylene oxide-modified polysiloxane.

The present invention consists in a water-borne photoimageable composition comprising
A) between 30 and 80 wt% of a latex binder polymer having carboxylic acid functionality which provides an acid number of between 50 and 250;
B) between 15 and 50 wt% of alpha,beta-ethylenically unsaturated monomers;
C) between 0.1 and 25 wt% of a photoinitiator or photoinitiator chemical system which generates free radicals; and
D) between 1 and 40 wt% of a neutralizing base and/or a polyether polyurethane associate thickener in an amount sufficient to stabilize an emulsion of said latex binder polymer; characterized in that said composition further comprises:
E) between 0.1 and 10 wt% of a mixture of cyclopoly (dimethylsiloxane) having a weight average molecular weight of less than 1,000 and polyether modified poly(dimethylsiloxane) at a weight ratio of between 1:9 and 9:1, said weight percentages being based on total weight of components A-E.

The water-borne photoimageable composition of the present invention, when applied as a layer, has a surface which is sufficiently non-tacky for artwork to be placed in direct contact therewith.

Latex binder polymers useful in the photoimageable composition of the present invention are typically prepared by emulsion polymerization of alpha, beta-unsaturated monomers, such as vinyl, acrylate or styrene monomers. Sufficient acid functional monomers are used to provide the acid number of between 50 and 250, preferably at least 100. A typical emulsion polymerization procedure and some examples of suitable emulsions are found in U.S. Patent No. 3,929,743, the teachings of which are incorporated herein by reference. Suitable emulsions can also be obtained commercially, e.g., Neocryl ® CL-340 (40% solids) available from ICI Resins U.S. and Acrysol® I-2074 (46% solids) available from Rohm and Haas.

Suitable acid functional monomers for use in forming the acid functional binder polymer have the formulae: 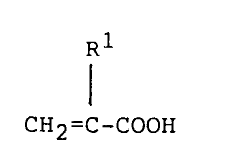 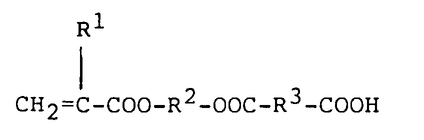 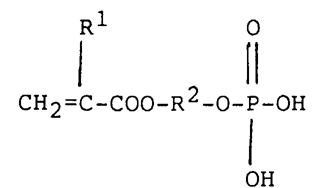 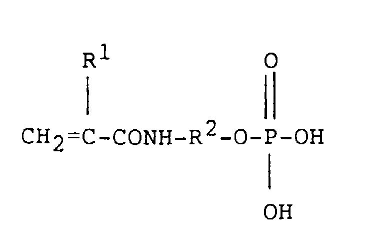 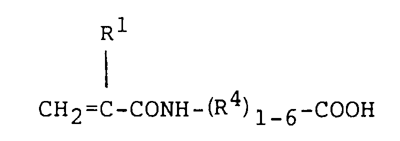 wherein R¹ represents a hydrogen atom or a methyl group, R² represents (CH₂)ₙ wherein n is an integer of 1 to 6, R³ represents an alkylene group having 1 to 6 carbon atoms or a phenylene group, and R⁴s are the same or different and are selected from CH₂ and CHOH.

Some specific examples of suitable acid functional monomers are acrylic acid, methacrylic acid, maleic acid, fumaric acid, citraconic acid, 2-acrylamido-2-methylpropanesulfonic acid, 2-propenoic acid-2-methyl-2-sulfoethyl ester, 2- hydroxyethyl acryloyl phosphate, 2-hydroxypropyl acryloyl phosphate, 2-hydroxy-alpha-acryloyl phosphate, etc. One or more of such acid functional monomers may be used to form the binder polymer. The acid functional monomers may be copolymerized with non-acid functional monomers, such as esters of acrylic acids, for example, methyl acrylate, methyl methacrylate, hydroxy ethyl acrylate, butyl methacrylate, octyl acrylate, 2-ethoxy ethyl methacrylate, t-butyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

To help ensure that the photoimageable composition is contact imageable, i.e., drys to a tack-free state, the glass transition temperature (T_{g}) of the latex binder polymer is preferably at least about 60°C as measured by Differential Scanning Calorimetry (DSC) @ 20°min. The polymers have a weight average molecular weight (Mw) of between about 500 and about 200,000 as measured by gel permeation chromatography (GPS) using a polystyrene standard.

To produce the image, this negative-acting photoimageable composition contains photopolymerizeable monomers, particularly alpha,beta-ethylenically unsaturated monomers, including a substantial portion of multifunctional monomers. Useful monomers include those, listed above, used to form the binder polymers. Particularly suitable monomers include multifunctional acrylic monomers, such as tetraethylene glycol diacrylate (TEGDA), trimethylol propane triacrylate (TMPTA), butanediol dimethacrylate (BDDMA) and pentaerythritol triacrylate (PETA). The monomer fraction may include both water-soluble and water-insoluble monomers; however, the monomer fraction should contain a sufficiently high proportion of water-insoluble (having solubilities in water at 20°C below about 0.3 g/100ml) monomers, e.g., above about 20 mole percent, so that the monomer fraction, as a whole, is insoluble in water.

To initiate polymerization of the monomers upon exposure to actinic radiation, the photoimageable composition contains an appropriate photoinitiator(s) or photoinitiator chemical system. Suitable photoinitiators include benzoin ethers, benzil ketals, acetophenones, benzophenones and related compounds with amines. Preferred initiators are thioxanthones, e.g., 2-isopropyl thioxanthones, particularly in conjunction with an amine.

In accordance with the invention, the poly(siloxane) fraction is a mixture of cyclodimethylsiloxanes and polyether modified dimethylsiloxanes at a weight ratio of between 1:9 and 9:1. An example of such a mixture is Dow Corning Q4-3667 which is an 80:20 mixture of polyether modified poly(dimethylsiloxanes) and cycle poly(dimethylsiloxanes). In addition to providing a tack-free surface, it is desirable that the material be water-soluble and not result in cratering or other coating defects. It is believed that after coating and during drying, the poly(siloxanes) tend to migrate to the surface to render the surface tack-free.

Cycle poly(dimethylsiloxanes) have the general formula -[Si(Me₂)-O]ₙ- where n is 3 to 60.

Polyether Modified poly(dimethylsiloxanes) have the qeneral formula: 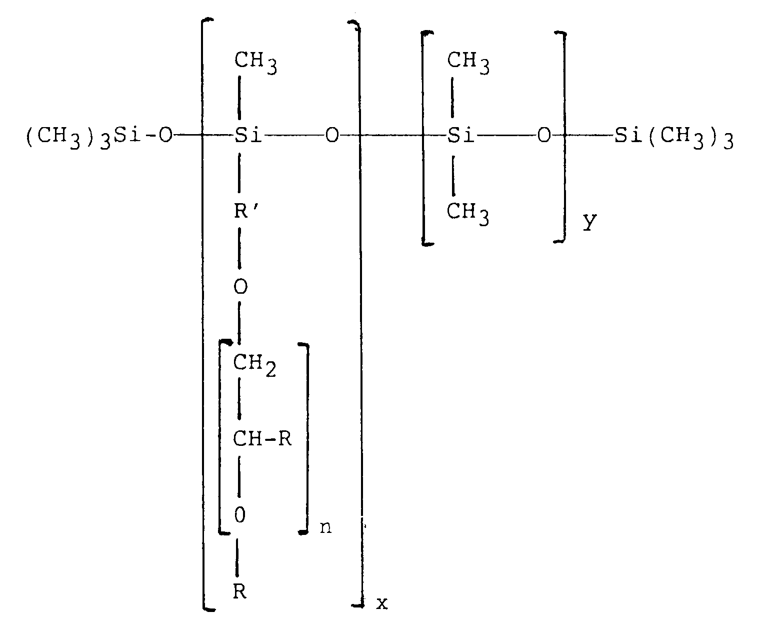 where n = 0 to 1500, x = 1 to 2,000, y = 1 to 2000, R = H or CH₃, R' = (CH₂)₀₋₅ and the groups subscripted x and y are in random order.

Low molecular weight cycle poly(dimethylsiloxanes) may have weight average molecular weights in the 100-600 Mw range; high molecular weight polyether-modified poly(dimethyl siloxanes) may have weight average molecular weights in the 2,000 to 500,000 Mw range.

The waterborne photoimageable composition preferably includes a surfactant which is a fluoroaliphatic oxyethylene adduct at a level of between about 0.5 and about 3.0 wt% based upon the combined weights of components A)-E) above. Such surfactants have the general formula:

CF₃-(CF₂)ₙ-Y-Xₘ-Z;

where n = 0 to 20, Y = SO₂-N(C₁-C₁₀alkyl), X = CH₂-CH₂-O or CH(CH₃)CH₂-O, m = 0 to 20, and Z = CH₂-CH₂-OH or CH(CH₃)-CH₂-OH.

Stabilization of the emulsion, including binder polymer is required. Emulsion stabilization and may be accomplished by at least partial neutralization with a base, as is taught in above- referenced U.S. Patent No. 5,045,435. Preferably, as is taught in U.S. Patent Application No. 08/199,037, stabilization of the emulsion and viscosity adjustment are achieved using a polyether polyurethane associate thickener. Polyether polyurethane thickeners are polymers having at least two hydrophobic segments which are the residues of hydrophobic isocyanates, generally isocyanates having isocyanate functionality of 2 or higher, and at least one hydrophilic polyether segment joining the hydrophobic segments by urethane linkages. The block polymers which act as associate thickener may take a variety of forms including ABA, (AB)ₙ, star polymers and the like. The polyether segments are formed from poly(alkylene oxide) segments, formed from monomers such as propylene oxide and ethylene oxide. To be sufficiently hydrophilic, generally it is necessary that at least about 3 mole percent of the poly(alkylene oxide) segment(s) be ethylene oxide residues. The hydrophobic portion of the isocyanate residue is typically an alkyl, cycloalkyl or aromatic moiety. Polyether polyurethane associate thickeners and their function are described, for example by A.J.M. Knoef, and H. Slingerland, "Urethane-Based Polymeric Thickeners for Aqueous Coating Systems" JOCCA, Sept. 1992, pp 335-338; J.H. Bieleman et al. Polymers Paint Colour Journal 1986, V.176(4169) pp. 450-460; and A.J. Whitton and R.E. Van Doren Polymers Paint Colour Journal 1991, V.181(4286) pp. 374-377. Particularly suitable polyether polyurethane associate thickeners and their synthesis are described in U.S. Patent No. 4,079,028 to Emmons et al. Suitable polyether polyurethane associate thickeners are also described in U.S. Patents Nos. 4,426,485 to Hoy et al. and 4,743,698 to Ruffner et al. Examples of suitable commercially available associate thickeners are DSX1514 (Henkel) and QR708 (Rohm and Haas).

By using the polyether polyurethane associate thickener, less neutralization of the binder polymer latex is required. In some cases no neutralization is required. In other cases, it is desirable to neutralize the binder up to about 20% of the equivalent acid functionality of the binder polymer. Typically base will be added to neutralize at least about 2% of the acid functionality of the binder polymer. Neutralization may be done with ammonia; primary, secondary, or tertiary amines; or hydroxides. Preferred neutralizing bases are hydroxy functional tertiary amines. The addition of associate thickener in place of at lease some of the neutralizer allows for a smoother more uniform coating. The improved coating quality minimizes potential circuit board defects caused by thin spots or pin holes in the coating. In addition, when applied by roller coating, the photoimageable composition with associate thickener produces a smoother coating at lower roller compression. Low roller compression results in extended life of the rubber rollers.

Reducing neutralizers improves chemical resistance of the applied and dried photoimageable composition layer. When ammonia or amine use is reduced, odor is reduced. Associate thickeners reduce viscosity drift of the aqueous photoimageable composition. Even under high shear, viscosity tends to remain stable.

In addition to components A-E listed above, minor amounts (generally less than about 10 wt% total based on the weight of A-E) of conventional additives may be used, including; antifoam agents, antioxidants, dyes, adhesion promoters, slip aids, and other surface tension modifiers.

In a preferred method of preparing the waterborne photoimageable composition of the present invention, those components, such as initiators, antioxidants and dyes, most compatible with a hydrophobic phase are admixed with the monomer fraction to produce a monomer base and those components most compatible with an aqueous phase with the latex polymer, such as antifoam, neutralizer surfactant and associate thickener, are admixed to form a polymer mix. The hydrophobic phase and polymer mix are blended to form an hydrophobic phase-in-water emulsion. Subsequently, high boiling solvents, surfactants, including slip aids, surface tension modifiers, and adhesion promoters are added.

The final water-borne composition is generally between 20 and 40 wt. percent solids. In the waterborne composition, the binder comprises between 10 and 30 wt%, monomers from 3 to 20 wt%, initiator from 0.3 to 10 wt%, neutralizing base and/or thickener from 1.5 to 20 wt%, an poly(siloxane(s)) at between .02 and 1 wt%. If used, a fluoraliphatic oxyethylene adduct surfactant will typically be present at between .06 and 2 wt%, the percentages being based on the total water-borne composition.

The composition may be coated by any of the coating systems known in the art for coating solvent-borne photoimageable compositions, such as roll coating, dip coating, spray coating or curtain coating.

The compositions of the present invention are applied in a conventional manner, either as liquid compositions directly to a metal clad blank laminate or to a polymeric support sheet to form a dry film. After coating, the composition is dried to remove water and also to remove volatiles, such as ammonia or amine, water, etc., thereby rendering the solution polymer insoluble in acidic or neutral aqueous medium. As the photoimageable composition dries, the system coalesces into a continuous film. Drying is preferably carried out at somewhat elevated temperatures, both to hasten removal of the water, and to drive off the ammonia or volatile amine. Preferably, drying is carried out at a temperature of about 90°C.

In forming a dry film, a water-borne composition is applied to flexible support sheet, e.g., polyethylene terephthalate, and then dried to remove water and volatiles. Subsequently, a protective sheet, e.g., polyethylene, is applied to the photoimageable composition layer, and the dry film is rolled into reels. In drying the photoimageable composition layer, it is found desirable in some cases to leave a residual water content of between about 1 and about 2 wt. % (relative to solids of the photoimageable composition layer). This residual water acts to allow the photoimageable composition layer to conform to surface defects of a substrate, e.g., a copper-clad board, when laminated thereto.

Processing is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

Not only can waterborne primary imaging photoresists be provided in accordance with the invention, but solder mask-forming compositions can be provided as well. By solder mask is meant herein a hard, permanent layer which meets at least the minimal requirements of the abrasion resistance tests as defined in IPC-SM-84OB, Table 12, Summary of Criteria for Qualification/Conformance (Institute for Interconnecting Circuits). To become hard and permanent, it is generally necessary that the photoimageable composition be curable after exposure, development and processing of the board, e.g., by thermal and/or UV curing. One way to provide a post-cure is to provide binder polymer having free -OH groups in the backbone that may be cured, for example, by cross-linking with aminoplast resins, such as melamine/formaldehyde resins and urea/formaldehyde resins. Alternatively, the photoimageable composition may contain a compatible epoxy resin and a curative for the epoxy resin. It is found that water-borne photoimageable compositions in accordance with the invention exhibit excellent shelf lives after application to copper substrates and can remain on a copper-clad board upwards of several days.

The invention will now be described in greater detail by way of specific examples.

### Examples 1-4

Water-borne photoimageable compositions were formulated according to Table 1 below. Amounts are in grams. 2.3 grams of neutralizer represents about 15 % neutralization; 4.5 grams of neutralizer represents about 30% neutralization. Performance data is according to Table 2 below. "Monomer base" in Table 1 is per Table 3; all materials being mixed together, filtered and subsequently added to the aqueous portion.

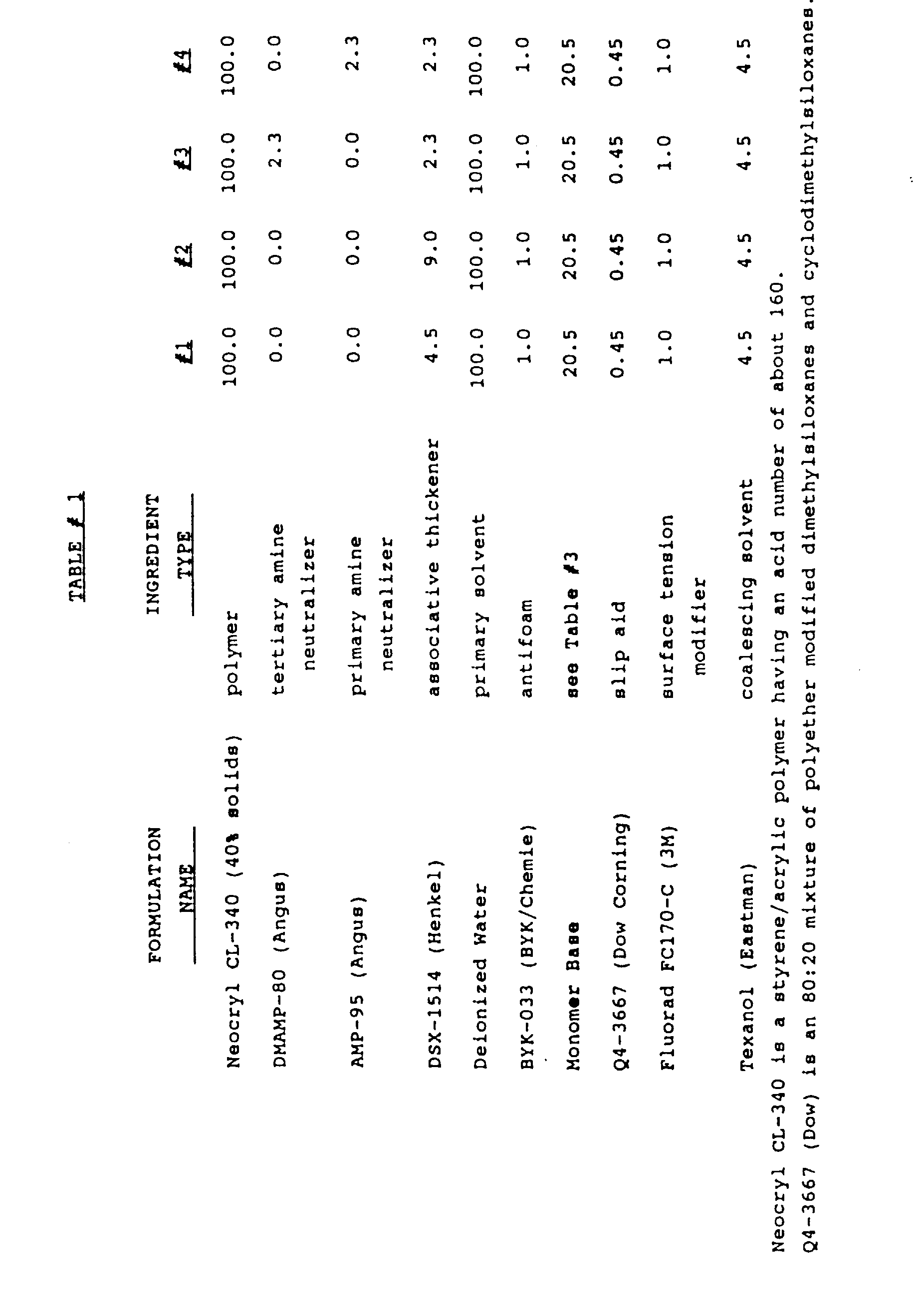

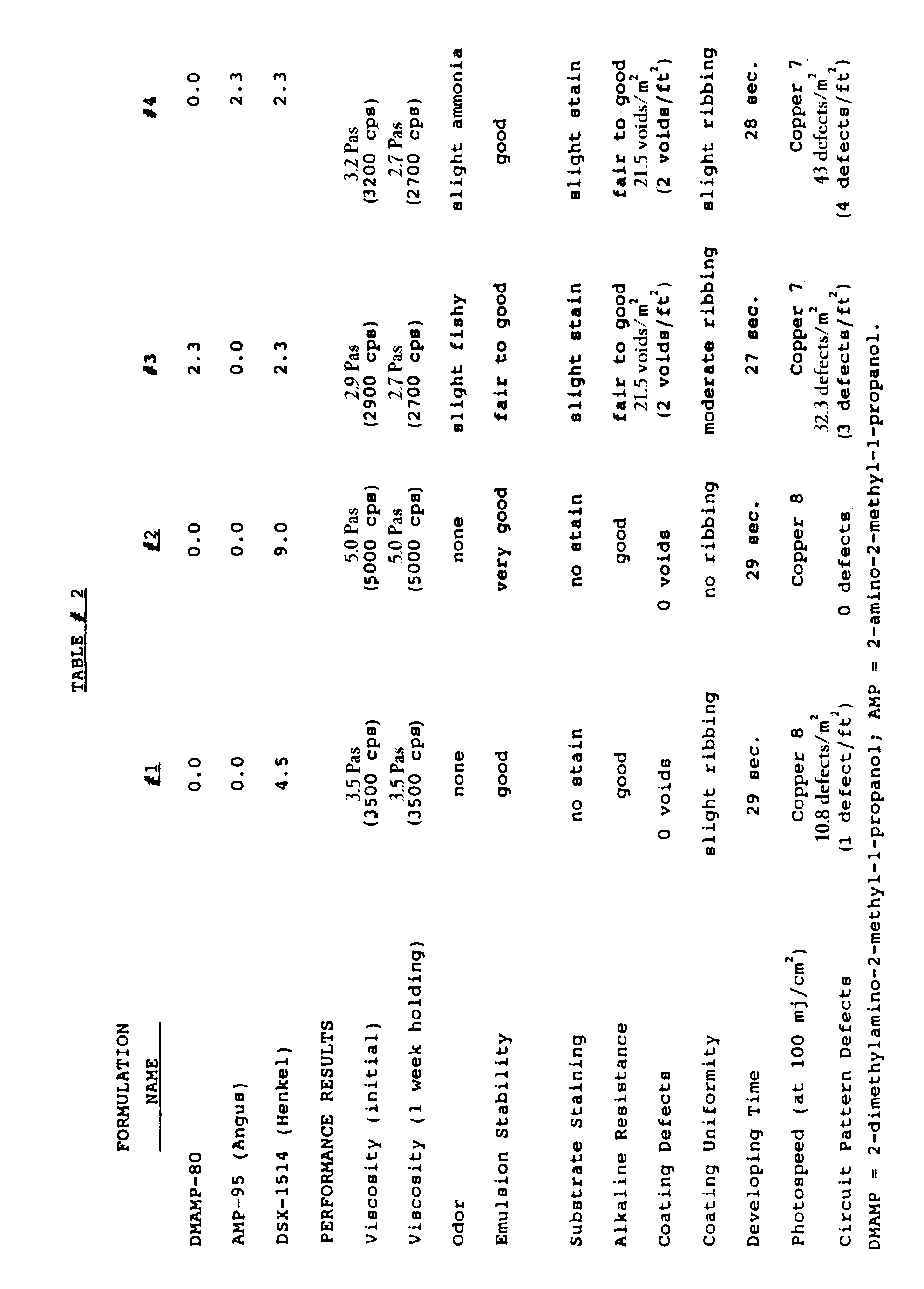

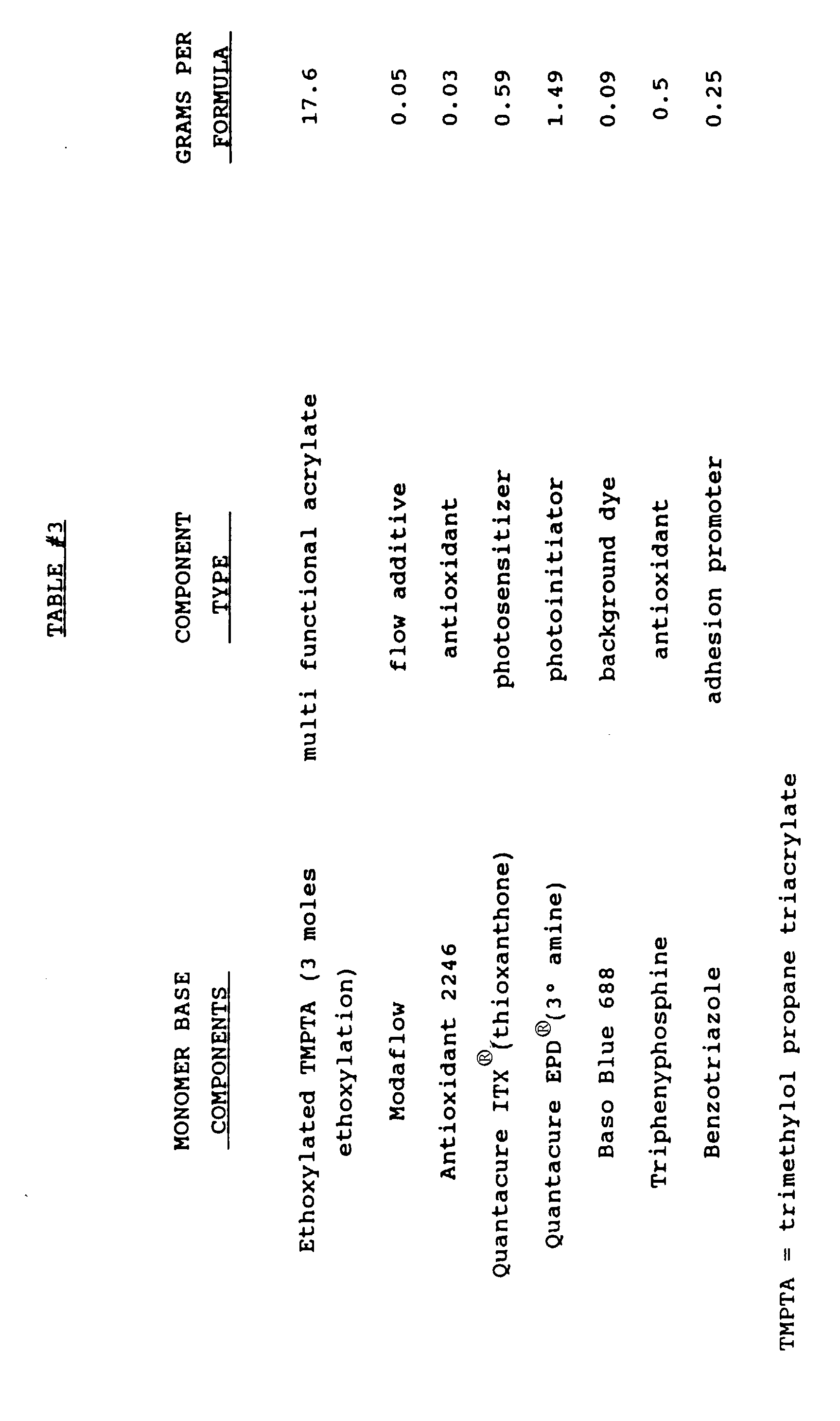

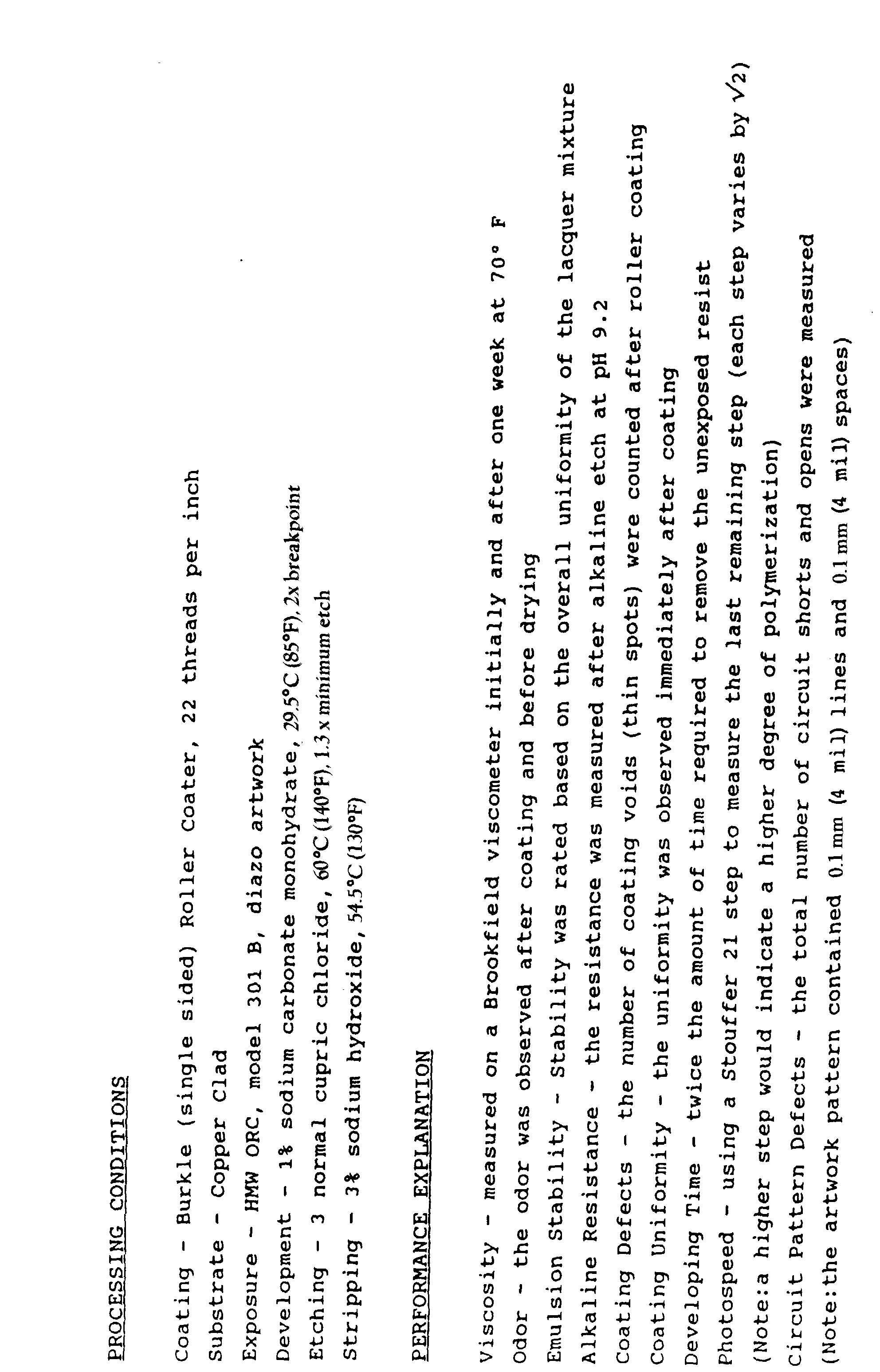

### Examples 5-32

Various poly(siloxanes) were tested in the base formula below using the processing conditions of Examples 1-4.

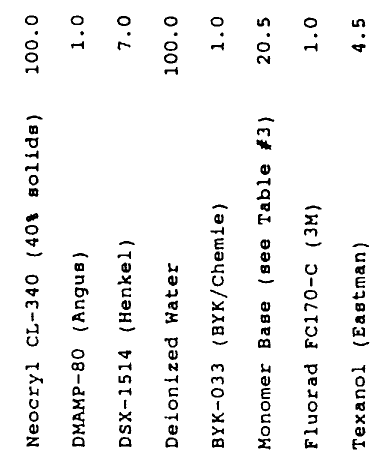

Results are as per Table 4 below

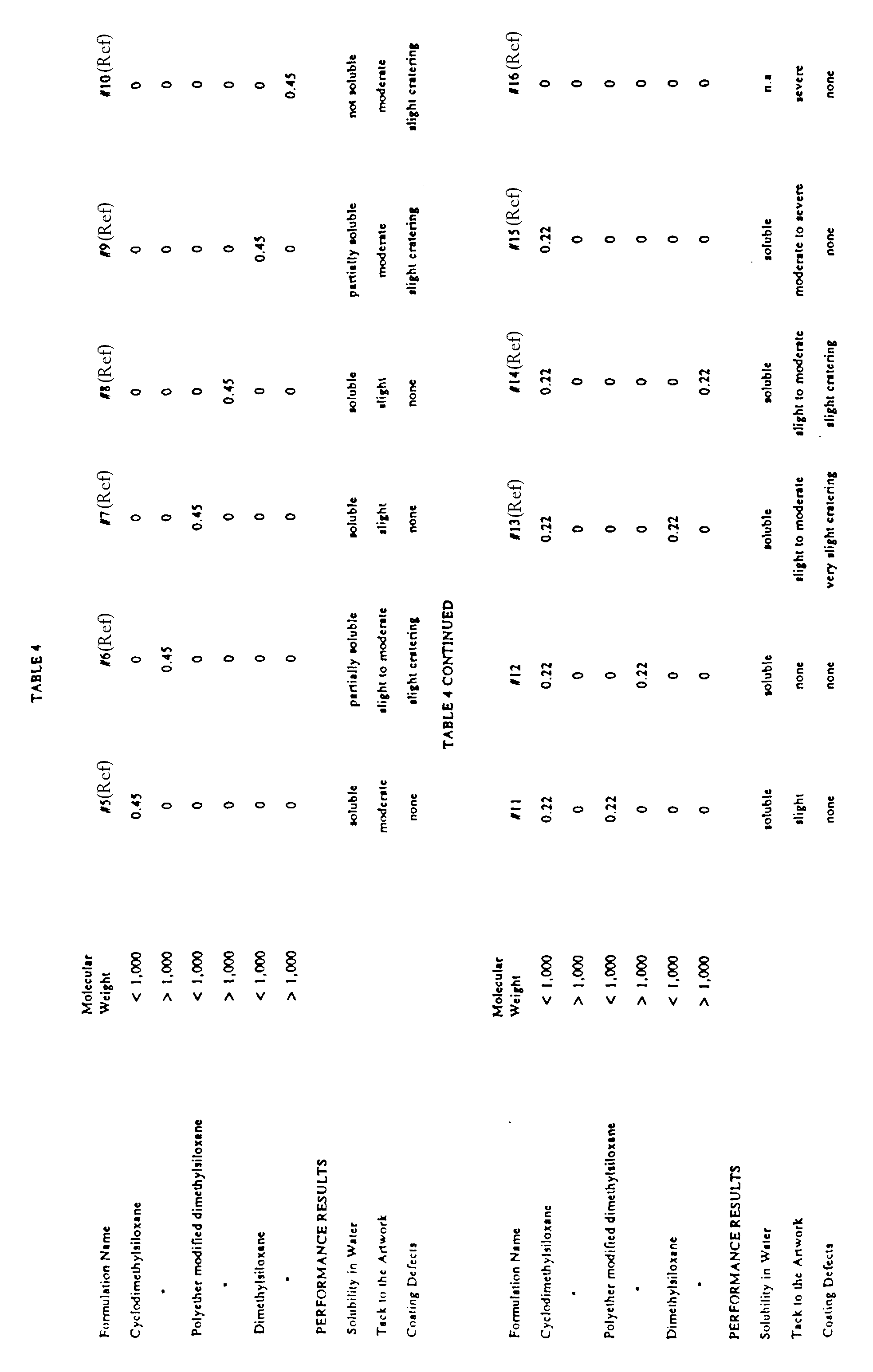

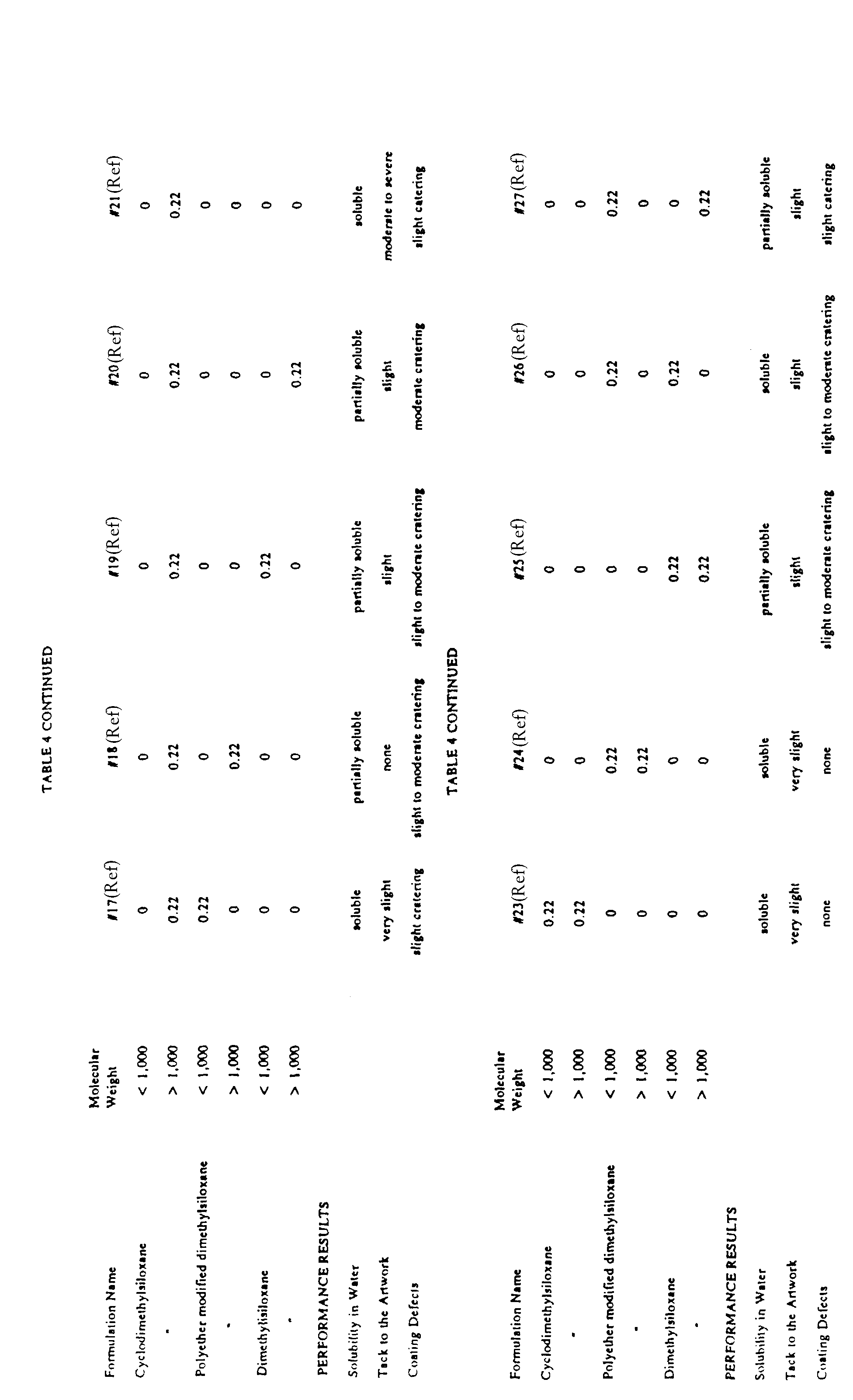

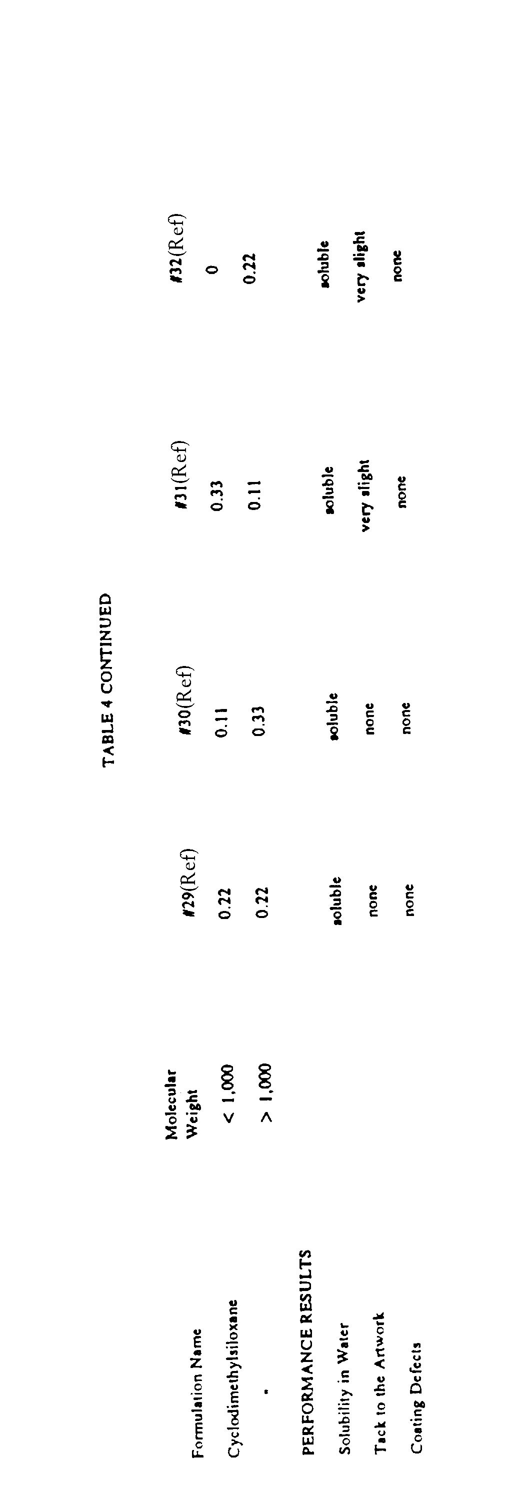

## Claims

1. A water-borne photoimageable composition comprising
A) between 30 and 80 wt% of a latex binder polymer having carboxylic acid functionality which provides an acid number of between 50 and 250;
B) between 15 and 50 wt% of alpha,beta-ethylenically unsaturated monomers;
C) between 0.1 and 25 wt% of a photoinitiator or photoinitiator chemical system which generates free radicals; and
D) between 1 and 40 wt% of a neutralizing base and/or a polyether polyurethane associate thickener in an amount sufficient to stabilize an emulsion of said latex binder polymer; characterized in that said composition further comprises:
E) between 0.1 and 10 wt% of a mixture of cyclopoly (dimethylsiloxane) having a weight average molecular weight of less than 1,000 and polyether modified poly(dimethylsiloxane) at a weight ratio of between 1:9 and 9:1, said weight percentages being based on total weight of components A-E.

2. A photoimageable composition in accordance with claim 1 wherein said cyclopoly(dimethylsiloxane) has a weight average molecular weight of 100 to 600.

3. A photoimageable composition according to any preceding claim wherein the polyether modified poly(dimethylsiloxane) has a weight average molecular weight of more than 1000.

4. A photoimageable composition according to claim 3 wherein the weight average molecular weight of the modified poly(dimethylsiloxane) is from 2,000 to 500,000.

5. A photoimageable composition according to any preceding claim which contains 20 to 40 wt.% solids.

6. A photoimageable composition according to claim 5 which comprises
10 to 30 wt.% of binder polymer (A),
3 to 20 wt.% of unsaturated monomers (B),
0.3 to 10 wt.% of photoinitiator (C),
1.5 to 20 wt.% of neutralizing base and/or thickener (D) and
0.02 to 1 wt.% of polysiloxanes (E), the percentages being based on the total water-borne composition.

7. A photoimageable composition according to claim 6 which additionally contains 0.06 to 2 wt.%, based on the total composition, of a fluoroaliphatic oxyethylene adduct surfactant.

8. A dry film comprising a polymeric support sheet and a layer of a photoimageable composition formed by applying to the sheet a water-borne photoimageable composition according to any preceding claim.

## Patentansprüche

1. Wäßrige Lichtabbildungszusammensetzung mit
A. 30 bis 80 Gew. % eines Latexbindemittelpolymers mit Carbonsäurefunktionalität, welche eine Säurezahl zwischen 50 und 250 ergibt,
B. 15 bis 50 Gew.% von alpha-, beta-ethylenisch ungesättigten Monomeren,
C. 0,1 bis 25 Gew.% eines Photoinitiators oder Photoinitiatorchemikaliensystems, welches freie Radikale erzeugt, und
D. 1 bis 40 Gew. % einer neutralisierenden Base und/oder eines polyetherurethanverbundenen Verdickungsmittels in einer ausreichenden Menge, um eine Emulsion des Latexbindemittelpolymers zu stabilisieren,
**dadurch gekennzeichnet,** daß die Zusammensetzung weiterhin
E. 0,1 bis 10 Gew. % eines Gemisches von Cyclopoly-(dimethylsiloxan) mit einem Molekulargewicht (Gewichtsmittel) von weniger als 1000 und von polyethermodifiziertem Poly-(dimethylsiloxan) in einem Gewichtsverhältnis zwischen 1 : 9 und 9 : 1 umfaßt, wobei die Gewichtsprozentsätze auf dem Gesamtgewicht der Komponenten A bis E beruhen.

2. Lichtabbildungszusammensetzung nach Anspruch 1, in welcher das Cyclopoly-(dimethylsiloxan) ein Molekulargewicht (Gewichtsmittel) von 100 bis 600 hat.

3. Lichtabbildungszusammensetzung nach einem der vorausgehenden Ansprüche, in der das polyethermodifizierte Poly-(dimethylsiloxan) ein Molekulargewicht (Gewichtsmittel) von mehr als 1000 hat.

4. Lichtabbildungszusammensetzung nach Anspruch 3, in welcher das Molekulargewicht (Gewichtsmittel) des modifizierten Poly-(dimethylsiloxans) 2000 bis 50 000 beträgt.

5. Lichtabbildungszusammensetzung nach einem der vorausgehenden Ansprüche, die 20 bis 40 Gew.% Feststoffe enthält.

6. Lichtabbildungszusammensetzung nach Anspruch 5, die
10 bis 30 Gew.% Bindemittelpolymer (A),
3 bis 20 Gew.% ungesättigte Monomere (B),
0,3 bis 10 Gew.% Photoinitiator (C),
1,5 bis 20 Gew.% neutralisierende Base und/oder Verdickungsmittel (D) und
0,02 bis 1 Gew.% Polysiloxane (E)
umfaßt, wobei die Prozentsätze auf der gesamten wäßrigen Zusammensetzung beruhen.

7. Lichtabbildungszusammensetzung nach Anspruch 6, die zusätzlich 0,06 bis 2 Gew.%, bezogen auf die Gesamtzusammensetzung, eines oberflächenaktiven fluoraliphatischen Oxyethylenadduktes enthält.

8. Trockenfilm mit einem Polymerträgerbogen und einer Schicht einer Lichtabbildungszusammensetzung, die durch Aufbringung einer wäßrigen Lichtabbildungszusammensetzung nach einem der vorausgehenden Ansprüche auf dem Bogen gebildet wurde.

## Revendications

1. Composition photo-imageable en milieu aqueux comprenant
A) entre 30 et 80 % en poids d'un polymère liant sous forme de latex ayant une fonctionnalité acide carboxylique qui fournit un indice d'acide compris entre 50 et 250 ;
B) entre 15 et 50 % en poids de monomères α,β-éthyléniquement insaturés ;
C) entre 0,1 et 25 % en poids d'un photo-initiateur ou d'un système chimique photo-initiateur qui forme des radicaux libres ; et
D) entre 1 et 40 % en poids d'une base neutralisante et/ou un épaississant associé polyétherpolyuréthane en une quantité suffisante pour stabiliser une émulsion dudit polymère liant sous forme de latex ; caractérisé en ce que ladite composition comprend en outre :
E) entre 0,1 et 10 % en poids d'un mélange de cyclopoly(diméthylsiloxane) ayant un poids moléculaire moyen en poids inférieur à 1000 et un poly(diméthylsiloxane) modifié par un polyéther dans un rapport pondéral compris entre 1:9 et 9:1, lesdits pourcentages en poids étant rapportés au poids total des composants A-E.

2. Composition photo-imageable selon la revendication 1, où ledit cyclopoly(diméthylsiloxane) a un poids moléculaire moyen en poids de 100 à 600.

3. Composition photo-imageable selon l'une quelconque des revendications précédentes, où le poly(diméthylsiloxane) modifié au polyéther a un poids moléculaire moyen en poids de plus de 1 000.

4. Composition photo-imageable selon la revendication 3, où le poids moléculaire moyen en poids du poly(diméthylsiloxane) modifié est de 2000 à 500 000.

5. Composition photo-imageable selon l'une quelconque des revendications précédentes qui contient 20 à 40 % en poids de solidcs.

6. Composition photo-imageable selon la revendication 5, qui comprend
10 à 30 % en poids de polymère liant (A),
3 à 20 % en poids des monomères insaturés (B),
0,3 à 10 % en poids d'un photo-initiateur (C),
1,5 à 20 % en poids d'une base neutralisante et/ou d'un épaississant (D) et
0,02 à 1% en poids de polysiloxanes (E), les pourcentages étant rapportés à l'ensemble de la composition en milieu aqueux.

7. Composition photo-imageable selon la revendication 6, qui contient en plus 0,06 à 2 % en poids, par rapport à l'ensemble de la composition, d'un tensioactif adduct fluoroaliphatique oxyéthyléné.

8. Film sec comprenant une feuille de support polymère et une couche d'une composition photo-imageable formée en appliquant sur la feuille une composition photo-imageable en milieu aqueux selon l'une quelconque des revendications précédentes.
